# EUROPÄISCHE PATENTSCHRIFT

(11) **EP 1 981 097 B1**
(45) Veröffentlichungstag und Bekanntmachung des Hinweises auf die Patenterteilung: **11.08.2010**
(21) Anmeldenummer: 08101455.7
(22) Anmeldetag: 11.02.2008
(51) Int. Cl.: H01L 41/22

(54) **Verfahren zur Herstellung eines piezoelektrischen Aktors**
Method of fabricating a piezoelectric actuator
Procédé de fabrication d'un actionneur piézoélectrique

(30) Priorität: 10.04.2007 DE 102007016871
(43) Veröffentlichungstag der Anmeldung: 15.10.2008
(73) Patentinhaber: ROBERT BOSCH GMBH, 70442 Stuttgart (DE)
(72) Erfinder: Schuett, Klaus-Volker, 73249, Wernau (DE); Holst, Marco, 70597, Stuttgart (Hoffeld) (DE); Cromme, Peter, 96050, Bamberg (DE); Klotz, Claudia, 96047, Bamberg (DE)

(56) Entgegenhaltungen:
- WO-A-01/48834
- WO-A-02/089225
- DE-A1- 10 217 361
- DE-A1-102005 024 710
- JP-A- 62 088 382
- US-A1- 2002 084 872
- US-A1- 2007 047 991

## Beschreibung

### Stand der Technik

Die Erfindung betrifft ein Verfahren zur Herstellung eines piezoelektrischen Aktors für ein Brennstoffeinspritzventil . Speziell betrifft die Erfindung das Gebiet der Injektoren für Brennstoffeinspritzanlagen von luftverdichtenden, selbstzündenden Brennkraftmaschinen.

Aus der DE 102 17 361 A1 ist ein piezoelektrisches Element und eine mit diesem piezoelektrischem Element versehene Einspritzdüse bekannt. Das bekannte piezoelektrische Element umfasst eine Keramikaufschichtung, die abwechselnd übereinander gestapelt mehrere Keramikschichten aus piezoelektrischer Keramik und mehrere Innenelektrodenschichten enthält. Auf einem Teil der Oberfläche der Keramikaufschichtung ist eine organische Isolationsschicht aus organischem Material ausgebildet. Ferner ist auf der organischen Isolationsschicht eine anorganische Isolationsschicht aus anorganischem Material ausgebildet. Dabei hat die organische Isolationsschicht genügend Elastizität, um die Auslenkung des piezoelektrischen Elements zu absorbieren. Allerdings kann die organische Isolationsschicht den Feuchtigkeitsdurchgang nicht aktiv unterbinden und lässt Feuchtigkeit hinein. Allerdings unterbindet die anorganische Isolationsschicht den Feuchtigkeitsdurchgang, wobei die anorganische Isolationsschicht jedoch keine Elastizität hat.

Das aus der DE 102 17 361 A1 bekannte piezoelektrische Element und die mit diesem piezoelektrischen Element versehene Einspritzdüse haben den Nachteil, dass die Ausgestaltung relativ aufwändig ist. Ferner besteht das Problem, dass bei der Herstellung oder im Betrieb auftretende Öffnungen oder Risse in der anorganischen Isolationsschicht ein Eindringen von Brennstoff in die organische Isolationsschicht ermöglichen, wodurch es zu Kurzschlüssen zwischen den Innenelektrodenschichten kommt.

In der Schrift WO 02/089225 A2 ist ein piezoelektrisches Bauteil mit einer Passivierung auf seiner Oberfläche dargestellt.

### Offenbarung der Erfindung

Das erfindungsgemäße Herstellungsverfahren des piezoelektrischen Aktors mit den Merkmalen des Anspruchs 1 hat den Vorteil, dass eine relativ kostengünstige Herstellung ermöglicht ist, wobei ein zuverlässiger Schutz gegenüber Medien gewährleistet ist, und dass insbesondere eine hohe Zuverlässigkeit und Funktionsfähigkeit gewährleistet ist.

Durch die in den Unteransprüchen aufgeführten Maßnahmen sind vorteilhafte Weiterbildungen des im Anspruch 1 angegebenen Verfahrens möglich.

Vorteilhaft ist es, dass die Deckschicht eine chemische Beständigkeit gegenüber polaren und unpolaren Bestandteilen von Diesel, Benzin, Kerosin, Öl oder dergleichen aufweist. Die Deckschicht hindert den Aktorkörper dabei zumindest im Wesentlichen nicht oder nur teilweise in der Bewegung. Ferner haftet die Deckschicht vorzugsweise ausreichend gut auf dem Aktorkörper sowie gegebenenfalls einem metallischen oder keramischen Übergangsstück, insbesondere einem Aktorkopf oder Aktorfuß.

Der Aktorkörper kann ein- oder mehrstückig ausgestaltet sein, wobei im Falle eines mehrstückigen Aktorkörpers mehrere Aktorteilkörper stirnseitig zu einer Aktorreihe aneinandergefügt sind. Eine solche Aktorreihe kann gegebenenfalls auch Zwischenstücke, insbesondere keramische Zwischenplatten, aufweisen.

Die Deckschicht ist vorzugsweise so ausgestaltet, dass in einem Temperaturbereich von etwa -40° C bis etwa 140° C eine ausreichende Flexibilität gewährleistet ist.

Außerdem ist es vorteilhaft, dass die Deckschicht während der Verarbeitung niederviskose Eigenschaften aufweist. Dadurch wird die Verarbeitung, insbesondere das Aufbringen der Deckschicht auf den Aktorkörper und gegebenenfalls auf ein oder mehrere Übergangsstücke, erleichtert.

Ferner ist es vorteilhaft, dass die Deckschicht als thermisch leitende Deckschicht ausgebildet ist und eine ausreichende Wärmeleitfähigkeit aufweist, um die bei der regelmäßigen Betätigung des piezoelektrischen Aktors auftretende Verlustwärme an den den Aktor umgebenden Brennstoff abzuführen.

In vorteilhafter Weise ist die Deckschicht aus einem Perfluorpolyether-Gel oder einem Elastomer gebildet. Ferner ist es auch vorteilhaft, dass die Deckschichten aus einem Fluorsilikon oder einem Fluorkautschuk besteht. Das Aufbringen der Deckschicht kann in vorteilhafter Weise durch Träufeln mit oder ohne Rotation des Aktorkörpers aufgebracht werden. Das geträufelte Material kann während der Auftragung gleichzeitig durch Wärmeeintrag, eine IR-, UV- und/oder eine radioaktive Strahlung ganz oder teilweise gehärtet und/oder vernetzt werden. Die Deckschicht kann auch durch ein Druckverfahren mit oder ohne Rotation selektiv aufgedruckt werden, wobei eine gleichzeitige Vernetzung durch Wärmeeintrag, IR-, UV- und/oder radioaktive Strahlung erfolgen kann.

Vorteilhaft ist es, dass der Aktorkörper Längskanten aufweist und dass die Deckschicht erfindungsgemäß separat auf die Längskanten aufgeschichtet ist. Die Längskanten, die abgerundet ausgestaltet sein können, können beispielsweise durch ein Druckverfahren erfindungsgemäß einzeln vor oder nach den zwischen den Längskanten liegenden Flächen beschichtet werden. Dies hat den Vorteil, dass eine Kantenflucht und/oder eine unzureichende Dicke der Beschichtung, das heißt der herzustellenden Deckschicht, auf den runden oder eckigen Kanten des Aktors vermieden wird.

Die Deckschicht kann mit einem Sprühverfahren in vorteilhafter Weise selektiv oder nicht selektiv aufgebracht werden.

Der piezoelektrische Aktor kann auch ein Schichtsystem aufweisen, das zwei- oder mehrlagig auf den Aktorkörper aufgebracht ist. Insbesondere kann zumindest eine weitere elastische Deckschicht vorgesehen sein, die zumindest teilweise auf die Deckschicht geschichtet ist, wobei die weitere Deckschicht eine chemische Beständigkeit gegenüber einem Brennstoff aufweist. Die erste Deckschicht kann dabei als Zwischenschicht dienen, die unmittelbar auf die Oberfläche des piezoelektrischen Aktors aufgebracht ist. Die als Zwischenschicht dienende erste Deckschicht kann dabei auf zumindest ein metallisches oder keramisches Übergangsstück, insbesondere einen Aktorkopf oder einen Aktorfuß, zumindest teilweise aufgebracht sein, wodurch eine verbesserte Abdichtung im Bereich eines Übergangs zwischen dem Aktorkörper und dem Übergangsstück gewährleistet ist.

In vorteilhafter Weise ist die weitere Deckschicht aus einem Material gebildet, das aus der Gruppe der Parylene gewählt ist. Dabei kann zumindest ein Haftvermittler appliziert werden. Ferner kann die weitere Deckschicht auch selektiv aufgebracht werden. Des weiteren ist es möglich, dass die weitere Deckschicht thermisch, durch IR-, UV- und/oder durch radioaktive Strahlung in den Eigenschaften, insbesondere den Permeationseigenschaften, verbessert wird.

### Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt:
- Fig. 1: ein Brennstoffeinspritzventil mit einem piezoelektrischen Aktor in einer schematischen Schnittdarstellung;
- Fig. 2: den in Fig. 1 mit II bezeichneten Ausschnitt eines piezoelektrischen Aktors.

### Ausführungsformen der Erfindung

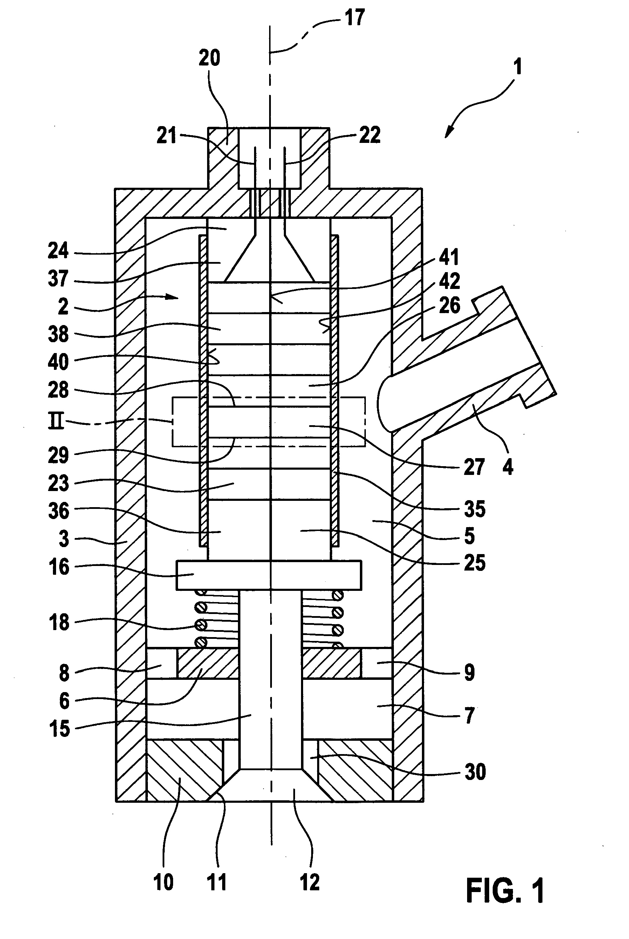

Fig. 1 zeigt ein Brennstoffeinspritzventil 1 mit einem piezoelektrischen Aktor 2 hergestellt nach dem erfindungsgemäßen Verfahren. Das Brennstoffeinspritzventil 1 kann insbesondere als Injektor für Brennstoffeinspritzanlagen von luftverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Der erfindungsgemäß hergestellte piezoelektrische Aktor 2 eignet sich besonders für solch ein Brennstoffeinspritzventil 1 und auch für eine inverse Ansteuerung des piezoelektrischen Aktors 2. Das Brennstoffeinspritzventil 1 und der erfindungsgemäß hergestellte piezoelektrische Aktor 2 eignen sich jedoch auch für andere Anwendungsfälle.

Das Brennstoffeinspritzventil 1 weist ein Ventilgehäuse 3 und einen mit dem Ventilgehäuse 3 verbundenen Brennstoffeinlassstutzen 4 auf. An den Brennstoffeinlassstutzen 4 ist eine Brennstoffleitung anschließbar, um das Brennstoffeinspritzventil 1 über ein Common-Rail oder direkt mit einer Hochdruckpumpe zu verbinden. Über den Brennstoffeinlassstutzen 4 kann dann Brennstoff in einen im Inneren des Ventilgehäuses 3 vorgesehenen Aktorraum 5 eingeleitet werden, so dass sich im Betrieb des Brennstoffeinspritzventils 1 Brennstoff in dem Aktorraum 5, in dem auch der piezoelektrische Aktor 2 vorgesehen ist, befindet. Der Aktorraum 5 ist durch ein Gehäuseteil 6 von einem ebenfalls im Inneren des Ventilgehäuses 3 vorgesehenen Brennstoffraum 7 getrennt. In dem Gehäuseteil 6 sind dabei Durchlassöffnungen 8, 9 ausgestaltet, um den über den Brennstoffeinlassstutzen 4 in den Aktorraum 5 geführten Brennstoff in den Brennstoffraum 7 zu leiten.

Das Ventilgehäuse 3 ist mit einem Ventilsitzkörper 10 verbunden, an dem eine Ventilsitzfläche 11 ausgebildet ist. Die Ventilsitzfläche 11 wirkt mit einem Ventilschließkörper 12 zu einem Dichtsitz zusammen. Dabei ist der Ventilschließkörper 12 einstückig mit einer Ventilnadel 15 ausgebildet, über die der Ventilschließkörper 12 mit einer im Aktorraum 5 vorgesehenen Druckplatte 16 verbunden ist. Dabei ist die Ventilnadel 15 durch das Gehäuseteil 6 entlang einer Achse 17 des Brennstoffeinspritzventils 1 geführt. Ein Federelement 18, das einerseits an dem Gehäuseteil 6 und andererseits an der Druckplatte 16 anliegt, beaufschlagt den piezoelektrischen Aktor 2 mit einer Vorspannkraft, wobei durch die Beaufschlagung außerdem die Ventilnadel 15 mittels der Druckplatte 16 betätigt wird, so dass der zwischen dem Ventilschließkörper 12 und der Ventilsitzfläche 11 gebildete Dichtsitz geschlossen ist.

Außerdem weist das Ventilgehäuse 3 ein Anschlusselement 20 auf, um das Anschließen einer elektrischen Zuleitung an das Brennstoffeinspritzventil 1 zu ermöglichen. Die elektrische Zuleitung kann dabei mittels eines Steckers an elektrische Leitungen 21, 22 angeschlossen werden. Die elektrischen Leitungen 21, 22 sind durch das Gehäuse 3 und einen an einen Aktorkörper 23 des Aktors 2 angefügten Aktorfuß 24 an den Aktorkörper 23 geführt. An den Aktorkörper 23 des piezoelektrischen Aktors 2 ist ferner ein Aktorkopf 25 angefügt, über den der Aktorkörper 23 entgegen der Kraft des Federelements 18 auf die Druckplatte 16 einwirkt. Der piezoelektrische Aktor 2 weist in dem dargestellten Ausführungsbeispiel den Aktorkörper 23, den Aktorfuß 24 und den Aktorkopf 25 auf, so dass ein Aktormodul gebildet ist.

Der Aktorkörper 23 des piezoelektrischen Aktors 2 weist eine Vielzahl von keramischen Schichten 26, 27 und eine Vielzahl von zwischen den keramischen Schichten 26, 27 angeordneten Elektrodenschichten 28, 29 auf. Dabei sind in der Fig. 1 zur Vereinfachung der Darstellung nur die keramischen Schichten 26, 27 sowie die Elektrodenschichten 28, 29 gekennzeichnet. Die Elektrodenschichten 28, 29 sind abwechselnd mit der elektrischen Leitung 21 und der elektrischen Leitung 22 verbunden, so dass alternierend positive und negative Elektroden zwischen den keramischen Schichten 26, 27 vorgesehen sind.

Über die elektrischen Leitungen 21, 22 kann der piezoelektrische Aktor 2 geladen werden, wobei sich dieser in Richtung der Achse 17 ausdehnt, so dass der zwischen dem Ventilschließkörper 12 und der Ventilsitzfläche 11 ausgebildete Dichtsitz geöffnet wird. Dadurch kommt es zum Abspritzen von Brennstoff aus dem Brennstoffraum 7 über einen Ringspalt 30 und den geöffneten Dichtsitz. Beim Entladen des piezoelektrischen Aktors 2 zieht sich dieser wieder zusammen, so dass der zwischen dem Ventilschließkörper 12 und der Ventilsitzfläche 11 ausgebildete Dichtsitz wieder geschlossen ist.

Die Verbindung der elektrischen Leitungen 21, 22 mit den Elektrodenschichten 28, 29 kann durch innenliegende Elektrodenanbindungen erfolgen. Es können allerdings auch außenliegende Elektrodenanbindungen vorgesehen sein. Der Aktorkörper 23 ist zwischen dem Aktorkopf 25 und dem Aktorfuß 24 angeordnet.

Der piezoelektrische Aktor 2 weist eine elastische Deckschicht 35 auf, die gegenüber Brennstoffen chemisch beständig ist. Die Deckschicht 35 ist einerseits auf eine Außenfläche 36 des Aktorkopfes 25, andererseits auf eine Außenfläche 37 des Aktorfußes 24 sowie auf eine Oberfläche 38 des Aktorkörpers 23 geschichtet. Dadurch ist eine zuverlässige Abdichtung des Aktorkörpers 23, insbesondere der Elektrodenschichten 28, 29 des Aktorkörpers 23, gegenüber einem im Aktorraum 5 vorgesehenen Brennstoff gewährleistet. Insbesondere wird ein Kurzschluss zwischen den Elektrodenschichten 28, 29 verhindert. Die Deckschicht 35 ist elektrisch isolierend ausgestaltet, so dass der Aktorkopf 25 und der Aktorfuß 24 sowohl aus einem metallischen als auch aus einem keramischen Material bestehen können. In dem dargestellten Ausführungsbeispiel sind der Aktorkopf 25 und der Aktorfuß 24 jeweils teilweise beschichtet. Es ist allerdings auch eine vollständige Beschichtung des Aktorkopfes 25 und/oder des Aktorfußes 24 an deren Außenflächen 36, 37 mit einer Deckschicht 35 möglich.

Die Deckschicht 35 ist elastisch ausgestaltet, so dass eine Betätigung des Aktorkörpers 23 möglich ist, ohne dass es zu Rissen in der Deckschicht 35 kommt. Ferner wird der Aktorkörper 23 nicht oder nur teilweise in seiner Bewegung gehindert. Die Deckschicht 35 weist eine ausreichend gute Haftung auf der Oberfläche 38 des Aktorkörpers 23 sowie auf den Außenflächen 36, 37 des Aktorkopfes 25 sowie des Aktorfußes 24 auf. Dadurch ist eine zuverlässige Abdichtung gewährleistet. Ferner sind die elastischen Eigenschaften der Deckschicht 35 vorzugsweise in einem Temperaturbereich von etwa -40°C bis etwa 140°C gewährleistet. Die Deckschicht 35 weist eine ausreichend große Wärmeleitfähigkeit auf, um die bei der periodischen Betätigung des Aktorkörpers 23 entstehende Wärme an den im Aktorraum 5 vorgesehenen Brennstoff abzuführen.

Die Deckschicht 35 weist eine gute chemische Beständigkeit gegen polare und unpolare Bestandteile von Diesel, insbesondere Diesel, der ganz oder teilweise aus biologischem Dieselkraftstoff besteht, Benzin, Kerosin und/oder Öl auf. Dadurch ist ein weiter Anwendungsbereich ermöglicht. Die Deckschicht 35 kann beispielsweise auf der Basis eines Perfluorethers oder eines Elastomers mit oder ohne Silikonseitengruppen hergestellt sein. Ferner kann die Deckschicht 35 auf der Basis eines Fluorsilikons oder eines Fluorkautschuks hergestellt sein. Eine Möglichkeit zur Aufbringung der Deckschicht 35 besteht darin, dass das Ausgangsmaterial durch Träufeln mit oder ohne Rotation des Aktorkörpers 23, an den gegebenenfalls Übergangsstücke 24, 25 angefügt sind, aufgebracht wird. Dabei kann das geträufelte Material während des Auftragens gleichzeitig durch Wärmeeintrag, durch IR-, durch UV-, oder radioaktive Strahlung ganz oder teilweise gehärtet und vernetzt werden.

Die Deckschicht 35 kann auch durch ein Druckverfahren mit oder ohne Rotation selektiv aufgedruckt werden, wobei gleichzeitig eine Vernetzung durch Wärmeeintrag, durch IR-, durch UV- und/oder radioaktive Strahlung erfolgen kann.

In dem dargestellten Ausführungsbeispiel weist der Aktorkörper 23 eine quadratische Querschnittsfläche auf. Längskanten 40, 41, 42 des Aktorkörpers 23 sowie gegebenenfalls Längskanten des Aktorkopfes 25 und des Aktorfußes 24 sind separat vor oder nach der Oberfläche 38 sowie den Außenflächen 36, 37 beschichtet, um eine zuverlässige Ausgestaltung der Deckschicht 35 zu ermöglichen. Speziell wird dadurch eine Kantenflucht oder eine unzureichende Dicke der Deckschicht 35 auf den runden oder eckigen Längskanten 40, 41, 42 des Aktorkörpers 25 sowie gegebenenfalls des Aktorkopfes und des Aktorfußes 24 vermieden.

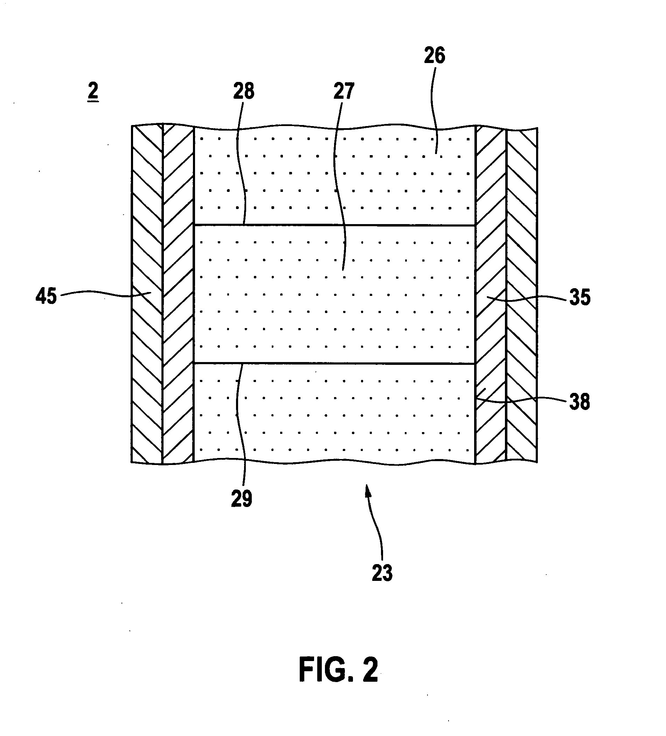

Fig. 2 zeigt den in Fig. 1 mit II bezeichneten Ausschnitt eines piezoelektrischen Aktors 2 eines Brennstoffeinspritzventils 1 entsprechend einem zweiten Ausführungsbeispiel. In diesem Ausführungsbeispiels ist auf die Deckschicht 35 eine weitere Deckschicht 45 aufgebracht, so dass ein mehrschichtiger Aufbau, nämlich in diesem Fall ein zweischichtiger Aufbau, gebildet ist. Die Deckschicht 35 dient dabei als Zwischenschicht, die direkt auf die Oberfläche 38 des Aktorkörpers 23 aufgebracht ist. Durch den mehrschichtigen Aufbau kann die Abdichtwirkung, insbesondere die Zuverlässigkeit der Abdichtung, weiter verbessert werden. Die weitere Deckschicht 45 kann beispielsweise aus einem Material aus der Gruppe der Parylene gebildet sein. Ferner kann für die Ausgestaltung des mehrschichtigen Aufbaus ein Haftvermittler appliziert werden. Die weitere Deckschicht 45 kann gegebenenfalls auch selektiv auf die Deckschicht 35 aufgebracht werden, um einen zuverlässigen Schutz der Deckschicht 35 und zugleich ein günstiges Dehnungsverhalten des Schichtaufbaus zu ermöglichen. Die weitere Deckschicht 35 kann thermisch, durch IR-, durch UV- und/oder durch radioaktive Strahlung in den Permeationseigenschaften verbessert werden.

Neben dem dargestellten zweischichtigen Aufbau sind auch Schichtaufbauten möglich, die neben den Deckschichten 35, 45 eine oder mehrere weitere Deckschichten aufweisen.

Die Erfindung ist nicht auf die beschriebenen Ausführungsbeispiele beschränkt.

## Patentansprüche

1. Verfahren zur Herstellung eines piezoelektrischen Aktors (2) für Brennstoffeinspritzventile, mit einem Aktorkörper (23), der eine Vielzahl von keramischen Schichten (26, 27) und eine Vielzahl von zwischen den keramischen Schichten (26, 27) angeordneten Elektrodenschichten (28, 29) aufweist, wobei zumindest eine elastische Deckschicht (35) zumindest teilweise auf den Aktorkörper (23) geschichtet wird, wobei die Deckschicht (35) eine chemische Beständigkeit gegenüber einem Brennstoff aufweist, und wobei der Aktorkörper (23) Längskanten (40, 41, 42) und zwischen den Längskanten (40, 41, 42) liegende Flächen (36, 37, 38) aufweist, **dadurch gekennzeichnet, dass** die Deckschicht (35) separat auf die Längskanten (40, 41, 42) aufgeschichtet wird, wobei die Längskanten (40, 41, 42) einzeln vor oder nach dem Aufbringen der Deckschicht (35) auf die zwischen den Längskanten (40, 41, 42) liegenden Flächen (36, 37, 38) beschichtet werden.

2. Verfahren nach Anspruch 1, **dadurch gekennzeichnet, dass** die Längskanten (40, 41, 42) durch ein Druckverfahren einzeln vor oder nach den zwischen den Längskanten (40, 41, 42) liegenden Flächen (36, 37, 38) beschichtet werden.

3. Verfahren nach Anspruch 1, **dadurch gekennzeichnet, dass** die Längskanten (40, 41, 42) durch ein Sprühverfahren einzeln vor oder nach den zwischen den Längskanten (40, 41, 42) liegenden Flächen (36, 37, 38) beschichtet werden.

4. Verfahren nach einem der Ansprüche 1 bis 3, **dadurch gekennzeichnet, dass** die Deckschicht (35) mit Rotation des Aktorkörpers (23) aufgebracht wird.

5. Verfahren nach einem der Ansprüche 1, 3 oder 4, **dadurch gekennzeichnet, dass** die Deckschicht (35) selektiv aufgebracht wird.

6. Verfahren nach einem der Ansprüche 1 bis 5, **dadurch gekennzeichnet, dass** eine weitere elastische Deckschicht (45) zumindest teilweise auf die elastische Deckschicht (35) aufgebracht wird.

## Claims

1. Method for producing a piezoelectric actuator (2) for fuel injection valves, having an actuator body (23) which has a multiplicity of ceramic layers (26, 27) and a multiplicity of electrode layers (28, 29) arranged between the ceramic layers (26, 27), with at least one elastic covering layer (35) being applied as a coating at least partially to the actuator body (23), with the covering layer (35) having a chemical resistance to a fuel, and with the actuator body (23) having longitudinal edges (40, 41, 42) and surfaces (36, 37, 38) situated between the longitudinal edges (40, 41, 42), **characterized in that** the covering layer (35) is applied as a coating to the longitudinal edges (40, 41, 42) separately, with the longitudinal edges (40, 41, 42) being coated individually before or after the application of the covering layer (35) to the surfaces (36, 37, 38) situated between the longitudinal edges (40, 41, 42).

2. Method according to Claim 1, **characterized in that** the longitudinal edges (40, 41, 42) are coated individually by means of an imprinting process before or after the surfaces (36, 37, 38) situated between the longitudinal edges (40, 41, 42).

3. Method according to Claim 1, **characterized in that** the longitudinal edges (40, 41, 42) are coated individually by means of a spraying process before or after the surfaces (36, 37, 38) situated between the longitudinal edges (40, 41, 42).

4. Method according to one of Claims 1 to 3, **characterized in that** the covering layer (35) is applied as the actuator body (23) is rotated.

5. Method according to one of Claims 1, 3 or 4, **characterized in that** the covering layer (35) is applied selectively.

6. Method according to one of Claims 1 to 5, **characterized in that** a further elastic covering layer (45) is applied at least partially to the elastic covering layer (35).

## Revendications

1. Procédé de fabrication d'un actionneur piézoélectrique (2) pour soupapes d'injection de carburant, comprenant un corps d'actionneur (23), qui présente une pluralité de couches céramiques (26, 27) et une pluralité de couches d'électrodes (28, 29) disposées entre les couches céramiques (26, 27), au moins une couche de revêtement élastique (35) étant appliquée au moins en partie sur le corps d'actionneur (23), la couche de revêtement (35) présentant une résistance chimique par rapport à un carburant et le corps d'actionneur (23) présentant des arêtes longitudinales (40, 41, 42) et des surfaces (36, 37, 38) situées entre les arêtes longitudinales (40, 41, 42), **caractérisé en ce que** la couche de revêtement (35) est appliquée séparément sur les arêtes longitudinales (40, 41, 42), les arêtes longitudinales (40, 41, 42) étant revêtues individuellement avant ou après l'application de la couche de revêtement (35) sur les surfaces (36, 37, 38) situées entre les arêtes longitudinales (40, 41, 42).

2. Procédé selon la revendication 1, **caractérisé en ce que** les arêtes longitudinales (40, 41, 42) sont revêtues par un procédé d'impression individuellement avant ou après les surfaces (36, 37, 38) situées entre les arêtes longitudinales (40, 41, 42).

3. Procédé selon la revendication 1, **caractérisé en ce que** les arêtes longitudinales (40, 41, 42) sont revêtues par un procédé de pulvérisation individuellement avant ou après les surfaces (36, 37, 38) situées entre les arêtes longitudinales (40, 41, 42).

4. Procédé selon l'une quelconque des revendications 1 à 3, **caractérisé en ce que** la couche de revêtement (35) est appliquée avec la rotation du corps d'actionnement (23).

5. Procédé selon l'une quelconque des revendications 1, 3 ou 4, **caractérisé en ce que** la couche de revêtement (35) est appliquée de manière sélective.

6. Procédé selon l'une quelconque des revendications 1 à 5, **caractérisé en ce qu'**une autre couche de revêtement élastique (45) est appliquée au moins en partie sur la couche de revêtement élastique (35).
